# EUROPEAN PATENT SPECIFICATION

(11) **EP 1 604 219 B1**
(45) Date of publication and mention of the grant of the patent: **13.12.2017**
(21) Application number: 04718356.1
(22) Date of filing: 08.03.2004
(51) Int. Cl.: G01R 33/07

(54) **HALL EFFECT SENSOR**
HALL-EFFEKT-SENSOR
CAPTEUR A EFFET HALL

(30) Priority: 08.03.2003 GB 0305352
(43) Date of publication of application: 14.12.2005
(73) Proprietor: Melexis Technologies NV, 3980 Tessenderlo (BE)
(72) Inventor: HILIGSMANN, Vincent, B-4052 BEAUFAYS (BE)
(74) Representative: Hertoghe, Kris Angèle Louisa
(86) International application number: PCT/IB2004/000637
(87) International publication number: WO 2004/079385

(56) References cited:
- WO-A-01/22037
- US-A- 6 064 199
- US-B1- 6 242 908
- US-B1- 6 404 188

## Description

The present invention relates mainly to a Hall effect sensor and in particular for a Hall effect sensor used for monitoring the position of ferrous gear wheels.

A Hall effect sensor can be used to detect the presence or absence of a tooth on a gear wheel. This is achieved by placing a Hall element between a biasing magnet and the gear wheel to measure variations in magnetic flux as the gear wheel turns. The output of the Hall element is input to a processing means which compares the output of the Hall element to a set of threshold parameters and thus outputs a binary signal indicative of the presence or absence of a tooth. There are typically a pair of threshold parameters: a rising signal becoming greater than the first threshold parameter indicating the presence of a tooth; and a falling signal dropping below the second threshold parameter indicating the absence of a tooth or vice-versa dependant on the relative orientation of the magnet and the Hall sensor.

US 6404188 B1 (RICKS) discloses a magnetic effect sensor system with a first set of regularly spaced teeth, and a second set of teeth interspersed within the first set. In use, the sensor senses the second set of teeth, whereby the rotational speed, rotational direction, and absolute position of the rotating component can be determined.

Such sensors are often used to monitor the position of the CAM and crankshafts in a modern gasoline or diesel internal combustion engine. The performance requirements demanded of such a sensor in automotive applications are dictated by the timing accuracy and repeatability needed to ensure that the emissions generated by the engine are within legal limits.

A further requirement for automotive applications is that of accommodating variations in mechanical tolerance. Such variations include changes in effective diameter of the gear wheel caused by temperature or manufacturing tolerance, and tooth to tooth variation caused by mechanical or material variations. Additionally variations can be caused by drift in the voltage supplied to the sensor by the engines battery.

To achieve the necessary accuracy known Hall sensors use averaging techniques to determine the average variation in flux between teeth and thus calculate a best fit pair of threshold parameters and track long term variations in these parameters. Such systems are limited since the best fit pair of threshold parameters may not be optimal for a large percentage of the teeth on the gear wheel.

It is therefore an object of the present invention to provide a method of monitoring a toothed gear wheel according to claim 1 and an improved Hall effect sensor according to claim 21. According to a first aspect of the present invention there is provided a method of monitoring a toothed gear wheel comprising the steps of: positioning a Hall element adjacent to the gear wheel to detect variations in magnetic flux as the gear wheel rotates; comparing the output of the Hall element to a set of threshold parameters and thus outputting a binary signal indicative of the presence or absence of a tooth, wherein different threshold parameters are provided for different teeth.

This method allows account to be taken of variation between teeth thus allowing for more accurate tracking of the gear wheel position.

Preferably, to increase the magnetic flux variation measured by the Hall element, a biasing magnetic flux is provided. The biasing flux may be provided by permanent or temporary magnetisation of the gear wheel or by the provision of a permanent magnet or electromagnet on the opposite side of the Hall element to the gear wheel.

Preferably, the different threshold parameters provided for each tooth are individual pairs of threshold parameters and most preferably, each pair of individual threshold parameters is optimised.

Preferably, the output of the Hall element is compared to the threshold parameters by a processing means and most preferably, the processing means monitors the output change of the Hall element associated with each individual tooth over time and uses long term averaging to calculate optimised threshold parameter pairs for each individual tooth. Advantageously, the processing means recalculates optimised threshold parameter pairs for each individual tooth subsequent to each time that particular tooth is detected. This recalculation compensates for inaccuracies caused by temperature variation or long term drift.

Preferably, the sensor contains a set of stored threshold parameter pairs allowing detection of teeth to commence as soon as the sensor is switched on. A set of stored threshold parameter pairs comprises a number of threshold parameter pairs.

The stored parameter pairs may be a standard stored set of parameters, used each time the sensor is switched on or they may be the optimised individual parameter pairs in use the last time the sensor was switched off. Alternatively, the sensor may have a multiple modes and may select one particular stored set of threshold parameters from a number of stored sets of threshold parameters when it is in a particular mode.

Preferably, the optimised individual threshold parameters are stored as deviations from the standard stored set of parameters. Deviations from a stored threshold are preferably stored digitally and are converted to an analogue voltage when applied to the stored threshold parameters. As the maximum size of a deviation is likely to be smaller in value than the threshold parameter itself, this reduces the amount of data storage space required for variations in the threshold parameter pairs and additionally allows conversion between analogue threshold parameters and their stored digital equivalents to run more quickly. Furthermore, if there is a data storage failure, only the deviations from the stored threshold parameters are lost. This allows monitoring to continue, if less accurately, until either the sensor is able to recalculate optimised parameters or until the sensor is repaired or replaced.

In order that the processing means is able to use the correct individual threshold parameters for each tooth, it should either be provided with information indicating the number of teeth on a particular gear wheel or alternatively it should be operative to be able to calculate the number of gear teeth on a given gear wheel by analysing the output of the Hall element for repeating patterns. Preferably, the sensor selects a reference tooth to enable synchronisation of the individual threshold parameters with the teeth on the gear wheel. Most preferably, the sensor is able to synchronise the individual threshold parameters with a gear wheel having fewer teeth than the maximum number of threshold parameters that the sensor can store.

According to a second aspect of the present invention there is provided a Hall sensor for monitoring the rotation of a gear wheel comprising: a Hall element, placed between a magnet and a gear wheel to detect variations in magnetic flux as the gear wheel rotates; a processing means, for comparing the output of the Hall element to a set of threshold parameters and thus outputting a binary signal indicative of the presence or absence of a tooth; and a data storage means for storing a set of threshold parameters for each individual tooth.

Preferably, the sensor is adapted to operate in accordance with the method of the first aspect of the present invention and the sensor may incorporate any or all of the features described in relation to the first aspect of the invention as appropriate.

Preferably, the processing means and the data storage means are incorporated in a single integrated circuit and most preferably the Hall element is additionally incorporated in a single integrated circuit with the processing means and the data storage means.

Preferably, the sensor may be connected to an engine controller and used to monitor the position of a gear wheel in an engine. Most preferably, the sensor is adapted to output information related to the position of the gear wheel to the engine controller and is additionally adapted to receive control signals from the engine controller. Typically in response to control signals received from the engine controller the sensor may automatically offset one or more individual threshold parameters by a particular value or the sensor may switch from one mode to another mode.

In order that the invention be more clearly understood, one embodiment is now described further by way of example only and with reference to the following drawings, in which: -
- Figure 1: shows a Hall sensor according to the present invention in use to monitor the position of a gear wheel and a plot representing the output of the Hall sensor and the variation in magnetic flux density as the gear wheel turns; and
- Figure 2: is a block diagram showing the components of the Hall sensor of figure 1.

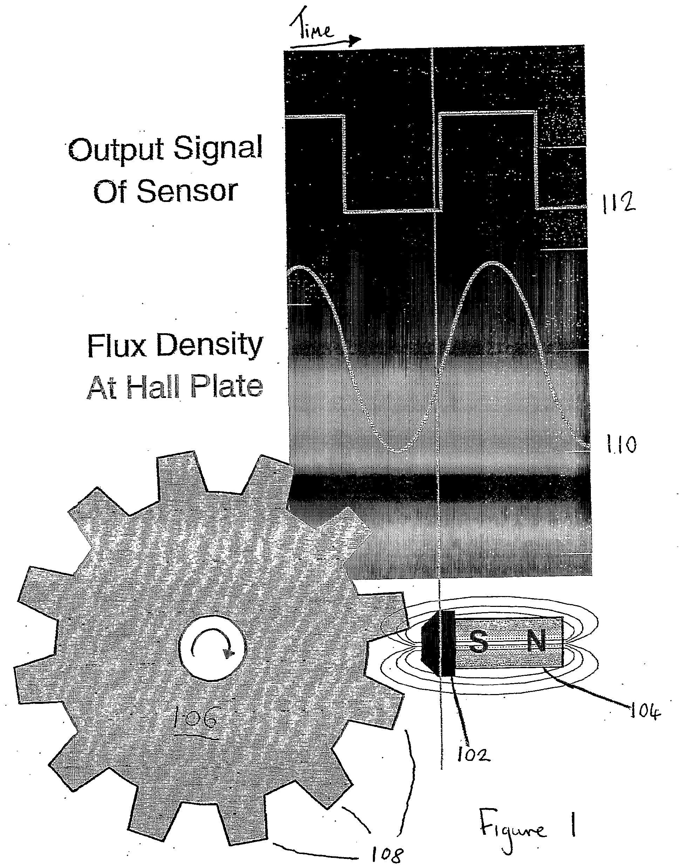

Referring to Figure 1, a Hall sensor 102 is placed between a magnet 104 and a ferrous gear wheel 106. The gear wheel 106 is turning in a clockwise direction, as it turns a succession of teeth 108 pass close to the Hall sensor 102. As a tooth 108 passes close to the Hall sensor, the flux emanating from the magnet 104 will become attracted to the lower reluctance path provided by the ferrous gear tooth 108 and thus the magnetic flux density in the vicinity of the Hall sensor 102 increases. When the wheel is turning, this leads to a periodic variation in the magnetic flux which is shown in figure 1 as line 110. Changes in the effective diameter of the gear wheel 106 or other mechanical or material variations between the individual teeth 108 mean that the peaks in line 110 are not constant from tooth to tooth. The size of the peaks or at least the relative size of the peaks associated with adjacent teeth 108 should however vary little with each subsequent rotation.

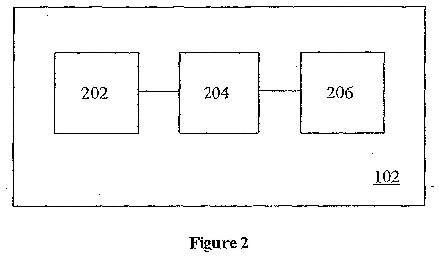

Referring to the block diagram Figure 2, the Hall sensor 102 is embodied by a single integrated circuit and comprises a Hall element 202, a processing means 204, and a data storage means 206. The Hall element 202 generates a voltage in response to and proportional to the local magnetic flux density, this voltage is input to the processing means 204. The processing means 204 monitors the output of the Hall element 202 and compares the output to a set of individual threshold parameter pairs for each tooth 108 stored in the data storage means 206.

When the output of Hall element 202 rises above the first threshold parameter of a threshold parameter pair, the output of the processing means 204 becomes high. When the output of the Hall element 202 subsequently drops below the second threshold parameter of the second parameter pair, the output of the processing means 204 becomes low. The processing means then proceeds to compare the output of the hall element 202 to the first threshold parameter of the threshold parameter pair associated with the next tooth 108. The output of the processing means 204 is thus a binary signal, being high when a tooth 108 is adjacent to the Hall element 202 and low otherwise as illustrated by line 112 in figure 1.

The output of the processing means 204 may be monitored by external circuitry (not shown) and means are provided for connecting the output of the processing means to further circuitry (not shown). In particular, by monitoring the frequency at which the output of the processing means 204 switches, the speed of rotation of the gear wheel 106 can be calculated. In addition, if the starting orientation of the gear wheel 106 is known, the instantaneous orientation of gear wheel 106 can be calculated.

Values for the first and second threshold parameters are stored in the data storage means 206 wherein there are individual first and second threshold parameters stored for each individual tooth 108.

The threshold parameter pairs stored for each individual tooth 108 are optimised. This is achieved by taking a long term average of the value of the output of the Hall element associated with each individual tooth and thus calculating appropriate values for the individual first and second threshold parameters. The long term average value is recalculated subsequent to each detection of the particular tooth by the processing means 204.

The optimised threshold parameters are stored as deviations from a standard stored pair of threshold parameters. The calculated deviations are stored as digital values in the data storage means 206 and are subsequently converted to analogue values and applied to the analogue voltages of the standard stored parameter pair when the particular tooth corresponding to the particular deviation is to be detected.

When the sensor is first turned on, the processing means 204 is able to use the stored standard pair of threshold parameters to begin detection of teeth immediately. Once detection of teeth 108 has begun, the processing means 204 begins to calculate optimised individual threshold parameters for each tooth 108. It is possible, if desired, to provide more than one stored pair of threshold parameters and the sensor can then select a particular pair of stored threshold parameters to use when beginning detection of teeth 108.

If the number of teeth a gear wheel has is known to the sensor, the processing means 204 first selects an individual tooth 108 to be a reference tooth. This enables the processing means 204 to synchronise the individual optimised threshold parameter pairs with the gear teeth 108. If alternatively, the number of teeth on a gear wheel is not known, the processing means 204 first monitors the output of the Hall element 202 to detect patterns and to thus determine how many teeth 108 gear wheel 106 has. The processing means 204 then selects a reference tooth as described above. The processing means 204 is thus able to synchronise the individual optimised threshold parameter pairs with the gear teeth 108 even if the number of teeth 108 is less than the maximum number of threshold parameter pairs that can be stored.

Means are provided to allow signals to be input to the processing means (not shown) by external circuitry. Input signals may inform the sensor of the number of teeth on a particular gear wheel, may cause the sensor to adjust the stored deviation for one or more individual parameters, or in particular may be used to switch the sensor from one mode to another mode.

The sensor described above is suitable for use in conjunction with an engine controller for monitoring the position of a gear wheel within an engine. The engine controller may send signals to the sensor causing the sensor to alter its mode, its threshold parameters or the number of teeth on a gear wheel it is trying to detect. Additionally the engine controller may act to change the mode of the sensor, adjust the operation of the engine or output an alarm in response to signals received from the sensor.

It is of course to be understood that the invention is not to be restricted to the details of the above embodiment which is described by way of example only.

## Claims

1. A method of monitoring a toothed gear wheel comprising the steps of :
positioning a Hall element (102) adjacent to the gear wheel (106) to detect variations in magnetic flux as the gear wheel rotates; comparing the output of the Hall element to a set of threshold parameters and thus outputting a binary signal indicative of the presence or absence of a tooth (108), wherein different threshold parameters are provided for different teeth, **characterised in that** the different threshold parameters provided for each different tooth are an individual pair of threshold parameters, wherein each individual pair of threshold parameters is optimized.

2. A method of monitoring a toothed gear wheel as claimed in claim 1 wherein to increase the magnetic flux variation measured by the Hall element (102), a biasing magnetic flux is provided.

3. A method of monitoring a toothed gear wheel as claimed in claim 2 wherein the biasing flux is provided by permanent magnetisation of the gear wheel (106).

4. A method of monitoring a toothed gear wheel as claimed in claim 2 wherein the biasing flux is provided by temporary magnetisation of the gear wheel (106).

5. A method of monitoring a toothed gear wheel as claimed in claim 2 wherein the biasing flux is provided by a permanent magnet (104) on the opposite side of the Hall element (102) to the gear wheel (106).

6. A method of monitoring a toothed gear wheel as claimed in claim 2 wherein the biasing flux is provided by an electromagnet (104) on the opposite side of the Hall element (102) to the gear wheel (106).

7. A method of monitoring a toothed gear wheel as claimed in any of the previous claims, wherein the output of the Hall element (102) is compared to the threshold parameters by a processing means (204).

8. A method of monitoring a toothed gear wheel as claimed in claim 7 wherein the processing means (204) monitors the output change of the Hall element (102) associated with each individual tooth (108) over time and uses long term averaging to calculate optimised threshold parameter pairs for each individual tooth.

9. A method of monitoring a toothed gear wheel as claimed in claim 7 or claim 8 wherein the processing means (204) recalculates optimised threshold parameter pairs for each individual tooth (108) subsequent to each time that particular tooth is detected.

10. A method of monitoring a toothed gear wheel as claimed in any one of the previous claims, wherein the sensor contains a set of stored threshold parameter pairs allowing detection of teeth to commence as soon as the sensor is switched on.

11. A method of monitoring a toothed gear wheel as claimed in claim 10, wherein the set of stored threshold parameter pairs comprises a number of threshold parameter pairs.

12. A method of monitoring a toothed gear wheel as claimed in claim 11, wherein the stored parameter pairs are a standard stored set of parameters, used each time the sensor is switched on.

13. A method of monitoring a toothed gear wheel as claimed in claim 11, wherein the stored parameter pairs are the optimised individual parameter pairs in use the last time the sensor was switched off.

14. A method of monitoring a toothed gear wheel as claimed in claim 11, wherein the sensor has multiple modes and selects one particular stored set of threshold parameters from a number of stored sets of threshold parameters when it is in a particular mode.

15. A method of monitoring a toothed gear wheel as claimed in any one of claims 10 to 14 wherein the optimised individual threshold parameters are stored as deviations from the standard stored set of parameters.

16. A method of monitoring a toothed gear wheel as claimed in claim 15 wherein the deviations from a stored threshold are stored digitally and are converted to an analogue voltage when applied to the stored threshold parameters.

17. A method of monitoring a toothed gear wheel as claimed in any one of the previous claims, wherein in order that the processing means is able to use the correct individual threshold parameter pairs for each tooth, it is provided with information indicating the number of teeth on a particular gear wheel (106).

18. A method of monitoring a toothed gear wheel as claimed in any one of the previous claims, wherein in order that the processing means is able to use the correct individual threshold parameter pairs for each tooth, it is operative to calculate the number of gear teeth on a given gear wheel (106) by analysing the output of the Hall element (102) for repeating patterns.

19. A method of monitoring a toothed gear wheel as claimed in claim 18, wherein in order to analyse the output of the Hall element (102) for repeating patterns the sensor selects a reference tooth to enable synchronisation of the individual threshold parameter pairs with the teeth on the gear wheel (106).

20. A method of monitoring a toothed gear wheel as claimed in any preceding claim wherein the sensor is able to synchronise the individual threshold parameter pairs with a gear wheel (106) having fewer teeth than the maximum number of threshold parameters that the sensor can store.

21. A Hall sensor for monitoring a toothed gear wheel comprising: a Hall element (102), placed between a magnet (104) and a gear wheel (106) to detect variations in magnetic flux as the gear wheel rotates; a processing means (204), for comparing the output of the Hall element (102) to a set of threshold parameters and thus outputting a binary signal indicative of the presence or absence of a tooth (108); and a data storage means (206) for storing a set of threshold parameters for each individual tooth, wherein different threshold parameters are provided for different teeth, **characterized in that** the different threshold parameters provided for each different tooth are an individual pair of threshold parameters, wherein each individual pair of threshold parameters is optimized.

22. A Hall sensor as claimed in claim 21 wherein the processing means (204) and the data storage means (206) are incorporated in a single integrated circuit.

23. A Hall sensor as claimed in claim 22 wherein Hall element (102) is incorporated in a single integrated circuit with the processing means and the data storage means.

24. A Hall sensor as claimed in any one of claims 21 to 23 wherein the sensor is connected to an engine controller and used to monitor the position of a gear wheel in an engine.

25. A Hall sensor as claimed in claim 24 wherein the sensor is adapted to output information related to the position of the gear wheel to the engine controller.

26. A Hall sensor as claimed in claim 24 or claim 25 wherein the sensor is adapted to receive control signals from the engine controller.

27. A Hall sensor as claimed in claim 26 wherein in response to control signals received from the engine controller the sensor automatically offsets one or more individual threshold parameters by a particular value.

28. A Hall sensor as claimed in claim 26 or claim 27 wherein in response to control signals received from the engine controller the sensor switches from one mode to another mode.

## Patentansprüche

1. Verfahren zum Überwachen eines Zahnrads, das die folgenden Schritte umfasst:
Positionieren eines Hallelements (102) benachbart zu dem Zahnrad (106), um Variationen des magnetischen Flusses zu erfassen, während sich das Zahnrad dreht; Vergleichen der Ausgabe des Hallelements mit einem Satz von Schwellenparametern und daher Ausgeben eines binären Signals, das auf die Gegenwart oder Abwesenheit eines Zahns (108) hinweist, wobei unterschiedliche Schwellenparameter für unterschiedliche Zähne bereitgestellt sind, **dadurch gekennzeichnet, dass** die unterschiedlichen Schwellenparameter, die für jeden unterschiedlichen Zahn bereitgestellt sind, ein individuelles Paar von Schwellenparametern sind, wobei jedes individuelle Paar von Schwellenparametern optimiert ist.

2. Verfahren zum Überwachen eines Zahnrads nach Anspruch 1, wobei zum Erhöhen der Variation des magnetischen Flusses, der durch das Halteelement (102) gemessen wird, ein vorspannender magnetischer Fluss bereitgestellt wird.

3. Verfahren zum Überwachen eines Zahnrads nach Anspruch 2, wobei der Vorspannfluss durch Dauermagnetisierung des Zahnrads (106) bereitgestellt wird.

4. Verfahren zum Überwachen eines Zahnrads nach Anspruch 2, wobei der Vorspannfluss durch vorübergehendes Magnetisieren des Zahnrads (106) bereitgestellt wird.

5. Verfahren zum Überwachen eines Zahnrads nach Anspruch 2, wobei der Vorspannfluss durch einen Dauermagnet (104) auf der entgegengesetzten Seite des Hallelements (102) zu dem Zahnrad (106) bereitgestellt wird.

6. Verfahren zum Überwachen eines Zahnrads nach Anspruch 2, wobei der Vorspannfluss durch einen Elektromagnet (104) auf der entgegengesetzten Seite des Hallelements (102) zu dem Zahnrad (106) bereitgestellt wird

7. Verfahren zum Überwachen eines Zahnrads nach einem der vorhergehenden Ansprüche, wobei die Ausgabe des Hallelements (102) mit den Schwellenparametern durch ein Verarbeitungsmittel (204) verglichen wird.

8. Verfahren zum Überwachen eines Zahnrads nach Anspruch 7, wobei das Verarbeitungsmittel (204) die Ausgabeänderung des Hallelements (102), das mit jedem einzelnen Zahn (108) assoziiert ist, im Laufe der Zeit überwacht und Langzeitmittelung zum Berechnen optimierter Schwellenparameterpaare für jeden einzelnen Zahn verwendet.

9. Verfahren zum Überwachen eines Zahnrads nach Anspruch 7 oder Anspruch 8, wobei das Verarbeitungsmittel (204) optimierte Schwellenparameterpaare für jeden einzelnen Zahn (108) im Anschluss an jedes Mal, dass ein bestimmter Zahn erfasst wird, neu berechnet.

10. Verfahren zum Überwachen eines Zahnrads nach einem der vorhergehenden Ansprüche, wobei der Sensor einen Satz gespeicherter Schwellenparameterpaare enthält, der erlaubt, dass das Erfassen von Zähnen sofort beginnt, wenn der Sensor eingeschaltet wird.

11. Verfahren zum Überwachen eines Zahnrads nach Anspruch 10, wobei der Satz gespeicherter Schwellenparameterpaare eine Anzahl von Schwellenparameterpaaren umfasst.

12. Verfahren zum Überwachen eines Zahnrads nach Anspruch 11, wobei die gespeicherten Parameterpaare ein gespeicherter Standardsatz von Parametern sind, der jedes Mal, wenn der Sensor eingeschaltet wird, verwendet wird.

13. Verfahren zum Überwachen eines Zahnrads nach Anspruch 11, wobei die gespeicherten Parameterpaare die optimierten einzelnen Parameterpaare sind, die beim letzten Ausschalten des Sensors in Einsatz waren.

14. Verfahren zum Überwachen eines Zahnrads nach Anspruch 11, wobei der Sensor mehrere Modi hat und einen bestimmten gespeicherten Satz von Schwellenparametern aus einer Anzahl gespeicherter Sätze von Schwellenparametern auswählt, wenn er in einem bestimmten Modus ist.

15. Verfahren zum Überwachen eines Zahnrads nach einem der Ansprüche 10 bis 14, wobei die optimierten individuellen Schwellenparameter als Abweichungen von dem gespeicherten Standardsatz von Parametern gespeichert sind.

16. Verfahren zum Überwachen eines Zahnrads nach Anspruch 15, wobei die Abweichungen von einem gespeicherten Schwellenwert digital gespeichert werden und in Analogspannung umgewandelt werden, wenn sie an die gespeicherten Schwellenparameter angewandt wird.

17. Verfahren zum Überwachen eines Zahnrads nach einem der vorhergehenden Ansprüche, wobei zum Ermöglichen, dass es die richtigen individuellen Schwellenparameterpaare für jeden Zahn verwendet, das Verarbeitungsmittel mit Informationen versehen wird, die die Anzahl von Zähnen auf einem bestimmten Zahnrad (106) angeben.

18. Verfahren zum Überwachen eines Zahnrads nach einem der vorhergehenden Ansprüche, wobei zum Ermöglichen, dass es die richtigen individuellen Schwellenparameterpaare für jeden Zahn verwendet, das Verarbeitungsmittel betrieben werden kann, um die Anzahl von Radzähnen auf einem gegebenen Zahnrad (106) durch Analysieren der Ausgabe des Hallelements (102) für sich wiederholende Muster zu berechnen.

19. Verfahren zum Überwachen eines Zahnrads nach Anspruch 18, wobei der Sensor zum Analysieren der Ausgabe des Hallelements (102) für sich wiederholende Muster einen Referenzzahn auswählt, um Synchronisation der einzelnen Schwellenparameterpaare mit den Zähnen auf dem Zahnrad (106) zu ermöglichen.

20. Verfahren zum Überwachen eines Zahnrads nach einem der vorhergehenden Ansprüche, wobei der Sensor fähig ist, die einzelnen Schwellenparameterpaare mit einem Zahnrad (106), das weniger Zähne hat als die maximale Anzahl von Schwellenparametern, die der Sensor speichern kann, zu synchronisieren.

21. Hallsensor zum Überwachen eines Zahnrads umfassend: ein Hallelement (102), das zwischen einem Magnet (104) und einem Zahnrad (106) platziert ist, um Variationen des magnetischen Flusses zu erfassen, während das Zahnrad dreht; ein Verarbeitungsmittel (204) zum Vergleichen der Ausgabe des Hallelements (102) mit einem Satz von Schwellenparametern und daher Ausgeben eines binären Signals, das auf die Gegenwart oder Abwesenheit eines Zahns (108) hinweist, und ein Datenspeichermittel (206) zum Speichern eines Satzes von Schwellenparametern für jeden einzelnen Zahn, wobei die unterschiedlichen Schwellenparameter für unterschiedliche Zähne bereitgestellt werden, **dadurch gekennzeichnet, dass** die unterschiedlichen Schwellenparameter, die für jeden unterschiedlichen Zahn bereitgestellt werden, einzelne Paare von Schwellenparametern sind, wobei jedes einzelne Paar von Schwellenparametern optimiert ist.

22. Hallsensor nach Anspruch 21, wobei das Verarbeitungsmittel (204) und das Datenspeichermittel (206) in eine einzige integrierte Schaltung eingebaut sind.

23. Hallsensor nach Anspruch 22, wobei das Halteelement (102) in eine einzige integrierte Schaltung mit dem Verarbeitungsmittel und dem Datenspeichermittel eingebaut ist.

24. Hallsensor nach einem der Ansprüche 21 bis 23, wobei der Sensor mit einer Maschinensteuervorrichtung verbunden ist und verwendet wird, um die Position eines Zahnrads in einer Maschine zu überwachen.

25. Hallsensor nach Anspruch 24, wobei der Sensor angepasst ist, um Informationen in Zusammenhang mit der Position des Zahnrads zu der Maschinensteuervorrichtung auszugeben.

26. Hallsensor nach Anspruch 24 oder Anspruch 25, wobei der Sensor angepasst ist, um Steuersignale von der Maschinensteuervorrichtung zu empfangen.

27. Hallsensor nach Anspruch 26, wobei der Sensor als Reaktion auf Steuersignale, die von der Maschinensteuervorrichtung empfangen werden, automatisch einen oder mehrere einzelne Schwellenparameter um einen bestimmten Wert versetzt.

28. Hallsensor nach Anspruch 26 oder Anspruch 27, wobei der Sensor als Reaktion auf Steuersignale, die von der Maschinensteuervorrichtung empfangen werden, von einem Modus auf einen anderen Modus umschaltet.

## Revendications

1. Procédé de surveillance d'une roue dentée d'engrenage, comprenant les étapes de :
le positionnement d'un élément à effet Hall (102) de façon adjacente à la roue dentée d'engrenage (106) pour détecter des variations de flux magnétique lorsque la roue dentée d'engrenage est en rotation ; la comparaison de la sortie de l'élément à effet Hall à un ensemble de paramètres de seuil et ainsi l'envoi d'un signal binaire indicatif de la présence ou de l'absence d'une dent (108), dans lequel différents paramètres de seuil sont fournis pour différentes dents, **caractérisé en ce que** les différents paramètres de seuil fournis pour chaque différente dent sont une paire individuelle de paramètres de seuil, dans lequel chaque paire individuelle de paramètres de seuil est optimisée.

2. Procédé de surveillance d'une roue dentée d'engrenage selon la revendication 1, dans lequel, pour augmenter la variation de flux magnétique mesurée par l'élément à effet Hall (102), un flux magnétique de polarisation est fourni.

3. Procédé de surveillance d'une roue dentée d'engrenage selon la revendication 2, dans lequel le flux de polarisation est fourni par magnétisation permanente de la roue dentée d'engrenage (106).

4. Procédé de surveillance d'une roue dentée d'engrenage selon la revendication 2, dans lequel le flux de polarisation est fourni par magnétisation temporaire de la roue dentée d'engrenage (106).

5. Procédé de surveillance d'une roue dentée d'engrenage selon la revendication 2, dans lequel le flux de polarisation est fourni par un aimant permanent (104) sur le côté de l'élément à effet Hall (102) opposé à la roue dentée d'engrenage (106).

6. Procédé de surveillance d'une roue dentée d'engrenage selon la revendication 2, dans lequel le flux de polarisation est fourni par un électroaimant (104), sur le côté de l'élément à effet Hall (102) opposé à la roue dentée d'engrenage (106).

7. Procédé de surveillance d'une roue dentée d'engrenage selon l'une quelconque des revendications précédentes, dans lequel la sortie de l'élément à effet Hall (102) est comparée aux paramètres de seuil par un moyen de traitement (204).

8. Procédé de surveillance d'une roue dentée d'engrenage selon la revendication 7, dans lequel le moyen de traitement (204) surveille le changement de sortie de l'élément à effet Hall (102) associé à chaque dent individuelle (108) au fil du temps et utilise une moyenne à long terme pour calculer des paires optimisées de paramètres de seuil pour chaque dent individuelle.

9. Procédé de surveillance d'une roue dentée d'engrenage selon la revendication 7 ou la revendication 8, dans lequel le moyen de traitement (204) recalcule des paires optimisées de paramètres de seuil pour chaque dent individuelle (108) après chaque instant auquel cette dent particulière est détectée.

10. Procédé de surveillance d'une roue dentée d'engrenage selon l'une quelconque des revendications précédentes, dans lequel le capteur contient un ensemble de paires stockées de paramètres de seuil permettant à la détection de dents de commencer dès que le capteur est allumé.

11. Procédé de surveillance d'une roue dentée d'engrenage selon la revendication 10, dans lequel l'ensemble de paires stockées de paramètres de seuil comprend un nombre de paires de paramètres de seuil.

12. Procédé de surveillance d'une roue dentée d'engrenage selon la revendication 11, dans lequel les paires stockées de paramètres sont un ensemble stocké standard de paramètres, utilisé à chaque fois que le capteur est allumé.

13. Procédé de surveillance d'une roue dentée d'engrenage selon la revendication 11, dans lequel les paires stockées de paramètres sont les paires optimisées individuelles de paramètres utilisées la dernière fois que le capteur a été éteint.

14. Procédé de surveillance d'une roue dentée d'engrenage selon la revendication 11, dans lequel le capteur possède de multiples modes et sélectionne un ensemble stocké particulier de paramètres de seuil parmi un nombre d'ensembles stockés de paramètres de seuil lorsqu'il est dans un mode particulier.

15. Procédé de surveillance d'une roue dentée d'engrenage selon l'une quelconque des revendications 10 à 14, dans lequel les paramètres de seuil individuels optimisés sont stockés sous forme d'écarts par rapport à l'ensemble stocké standard de paramètres.

16. Procédé de surveillance d'une roue dentée d'engrenage selon la revendication 15, dans lequel les écarts par rapport à un seuil stocké sont stockés numériquement et sont convertis en une tension analogique lors de l'application sur les paramètres de seuil stockés.

17. Procédé de surveillance d'une roue dentée d'engrenage selon l'une quelconque des revendications précédentes, dans lequel, afin que le moyen de traitement puisse utiliser les paires individuelles correctes de paramètres de seuil pour chaque dent, des informations lui sont fournies indiquant le nombre de dents sur une roue dentée d'engrenage particulière (106).

18. Procédé de surveillance d'une roue dentée d'engrenage selon l'une quelconque des revendications précédentes, dans lequel, afin que le moyen de traitement puisse utiliser les paires individuelles correctes de paramètres de seuil pour chaque dent, il fonctionne pour calculer le nombre de dents d'engrenage sur une roue dentée d'engrenage donnée (106) en analysant la sortie de l'élément à effet Hall (102) pour déterminer des types répétés.

19. Procédé de surveillance d'une roue dentée d'engrenage selon la revendication 18, dans lequel, afin d'analyser la sortie de l'élément à effet Hall (102) pour déterminer des types répétés, le capteur sélectionne une dent de référence pour permettre la synchronisation des paires individuelles de paramètres de seuil avec les dents sur la roue dentée d'engrenage (106).

20. Procédé de surveillance d'une roue dentée d'engrenage selon une quelconque revendication précédente, dans lequel le capteur peut synchroniser les paires individuelles de paramètres de seuil avec une roue dentée d'engrenage (106) possédant moins de dents que le nombre maximum de paramètres de seuil que le capteur peut stocker.

21. Capteur à effet Hall pour monitoring a roue dentée d'engrenage comprenant : un élément à effet Hall (102), placé entre un aimant (104) et une roue dentée d'engrenage (106) pour détecter des variations de flux magnétique lorsque la roue dentée d'engrenage est en rotation ; un moyen de traitement (204), pour comparer la sortie de l'élément à effet Hall (102) à un ensemble de paramètres de seuil et ainsi envoyer un signal binaire indicatif de la présence ou de l'absence d'une dent (108) ; et un moyen de stockage de données (206) pour stocker un ensemble de paramètres de seuil pour chaque dent individuelle, dans lequel différents paramètres de seuil sont fournie pour différentes dents, **caractérisé en ce que** les différents paramètres de seuil fournis pour chaque différente dent sont une paire individuelle de paramètres de seuil, dans lequel chaque paire individuelle de paramètres de seuil est optimisée.

22. Capteur à effet Hall selon la revendication 21, dans lequel le moyen de traitement (204) et le moyen de stockage de données (206) sont incorporés dans un seul circuit intégré.

23. Capteur à effet Hall selon la revendication 22, dans lequel l'élément à effet Hall (102) est incorporé dans un seul circuit intégré avec le moyen de traitement et le moyen de stockage de données.

24. Capteur à effet Hall selon l'une quelconque des revendications 21 à 23, dans lequel le capteur est connecté à un dispositif de commande de moteur et utilisé pour surveiller la position d'une roue dentée d'engrenage dans un moteur.

25. Capteur à effet Hall selon la revendication 24, dans lequel le capteur est adapté pour envoyer des informations connexes à la position de la roue dentée d'engrenage au dispositif de commande de moteur.

26. Capteur à effet Hall selon la revendication 24 ou la revendication 25, dans lequel le capteur est adapté pour recevoir des signaux de commande à partir du dispositif de commande de moteur.

27. Capteur à effet Hall selon la revendication 26, dans lequel, en réponse à des signaux de commande reçus à partir du dispositif de commande de moteur, le capteur compense automatiquement un ou plusieurs paramètres individuels de seuil selon une valeur particulière.

28. Capteur à effet Hall selon la revendication 26 ou la revendication 27, dans lequel, en réponse à des signaux de commande reçus à partir du dispositif de commande de moteur, le capteur permute d'un mode à un autre mode.
